(19) Europäisches Patentamt
European Patent Office
Office européen des brevets

(11) **EP 1 095 403 B1**

## (12) EUROPÄISCHE PATENTSCHRIFT

(45) Veröffentlichungstag und Bekanntmachung des Hinweises auf die Patenterteilung:
**31.03.2010 Patentblatt 2010/13**

(51) Int Cl.:
***H01L 21/782*** *(2006.01)*

(21) Anmeldenummer: **00931029.3**

(22) Anmeldetag: **26.04.2000**

(86) Internationale Anmeldenummer:
**PCT/DE2000/001295**

(87) Internationale Veröffentlichungsnummer:
**WO 2000/067312 (09.11.2000 Gazette 2000/45)**

(54) **VERFAHREN ZUR BESEITIGUNG VON DEFEKTEN VON SILIZIUMKÖRPERN DURCH SELEKTIVE ÄTZUNG**

METHOD FOR REMOVING DEFECTS FROM SILICON BODIES BY A SELECTIVE ETCHING PROCESS

PROCEDE D'ELIMINATION DE DEFAUTS DE CORPS EN SILICIUM PAR ATTAQUE SELECTIVE

(84) Benannte Vertragsstaaten:
**DE FR GB NL**

(30) Priorität: **29.04.1999 DE 19919471**

(43) Veröffentlichungstag der Anmeldung:
**02.05.2001 Patentblatt 2001/18**

(73) Patentinhaber: **ROBERT BOSCH GMBH**
**70442 Stuttgart (DE)**

(72) Erfinder:
• **SPITZ, Richard**
**D-72766 Reutlingen (DE)**
• **UEBBING, Helga**
**D-72770 Reutlingen (DE)**
• **EIMERS-KLOSE, Doerte**
**D-72762 Reutlingen (DE)**
• **LAERMER, Franz**
**D-70437 Stuttgart (DE)**
• **SCHILP, Andrea**
**D-73525 Schwaebisch Gmuend (DE)**

(56) Entgegenhaltungen:
EP-A- 0 878 824    DE-A- 3 506 995
US-A- 5 350 480    US-A- 5 693 182

• **PATENT ABSTRACTS OF JAPAN vol. 015, no. 125 (E-1050), 27. März 1991 (1991-03-27) & JP 03 012921 A (TOSHIBA CORP), 21. Januar 1991 (1991-01-21)**
• **PATENT ABSTRACTS OF JAPAN vol. 014, no. 576 (E-1016), 21. Dezember 1990 (1990-12-21) & JP 02 250323 A (HITACHI LTD), 8. Oktober 1990 (1990-10-08)**
• **PATENT ABSTRACTS OF JAPAN vol. 1996, no. 06, 28. Juni 1996 (1996-06-28) & JP 08 031785 A (SONY CORP), 2. Februar 1996 (1996-02-02)**

**Beschreibung**

Die Erfindung betrifft ein Verfahren zur Beseitigung von Ausbrüchen, Verunreinigungen und/oder Schäden am Kristallgitter durch selektive Ätzung von Siliziumkörpern, insbesondere von Leistungsdioden nach Anspruch 1.

**Stand der Technik**

Bei der Herstellung von Siliziumleistungsdioden ist bekannt, aus einem Siliziumwafer, der beidseitig zur Erzeugung eines pn-Überganges über ganzflächige Dotierschritte mit einer n- bzw. p-Dotierung und nachfolgend beidseitig mit einer ganzflächigen Metallisierung versehen ist, vereinzelte Einzeldioden auszuschneiden, indem der gesamte Wafer zunächst in etwa 5 x 5 mm² große Quadrate oder Sechsecke zersägt wird, und die ausgesägten, derart vereinzelten Siliziumflächendioden anschließend geeignet aufgebaut und elektrisch kontaktiert werden. Die Dotierung und Metallisierung des Siliziumwafers erfolgt dabei in an sich bekannter Weise, wobei die Oberflächenmetallisierung beispielsweise aus einer Chrom-Nickel-Vanadium-Silber-Legierung (CrNiVAg) besteht.

Durch den Sägevorgang, der erforderlich ist, um aus dem Siliziumwafer Einzeldioden herzustellen, kommt es vielfach zu unregelmäßigen Ausbrüchen an der Sägekante, zu Verunreinigungen und zu Schäden am Kristallgitter, so daß die pn-Übergänge in den ausgesägten Einzeldioden teilweise oder bereichsweise beschädigt sind. Diese Schädigung hat dann erhöhte Leckströme zur Folge, was die erzeugte Diode in diesem Stadium letztlich unbrauchbar macht.

Aus diesem Grund muß.bei bekannten Herstellungsverfahren derartiger Siliziumleistungsdioden nach dem Sägen eine naßchemische Überätzung der Dioden erfolgen, wobei die beschädigten Siliziumbereiche abgetragen werden, so daß im Bereich der pn-Übergänge ein möglichst intaktes Kristallgitter wiederhergestellt wird.

Im Anschluß an den erfolgten chemischen Ätzabtrag der beschädigten Siliziumbereiche wird dann eine Passivierung der freiliegenden Siliziumkante vorgenommen, um die pn-Übergänge vor Umwelteinflüssen zu schützen und eine erneute Verschlechterung der elektronischen Eigenschaften über die Lebenszeit der Diode zuverlässig zu verhindern. Letzere Aufgabe ist nach dem heutigen Stand der Technik als gelöst zu betrachten.

Für den Ätzabtrag der beschädigten Siliziumbereiche an der Sägekante existieren jedoch derzeit keine befriedigenden Lösungen. Die naßchemische Ätzung, wie sie momentan vielfach durchgeführt wird, bringt aufgrund ihrer ausgeprägten Dotierungsselektivität beispielsweise ungünstige Ätzprofile mit erhöhter elektrischer Durchbruchgefahr und infolge von gelegentlichen Rückständen bei der Ätzung auch Ausbeutenachteile mit sich. Zudem verringert sich durch das beim naßchemischen Ätzen erzeugte Ätzprofil auch die mechanische Stabilität der Diode.

Weiterhin werden bei den derzeit bekannten Verfahren erst die fertig montierten Dioden der wäßrigen Ätzlösung ausgesetzt, was ein aufwendiges Handling für die Einzeldioden involviert. Zusammenfassend lassen sich also die aus dem Stand der Technik bekannten Verfahren zum Überätzen von aus einem Siliziumwafer ausgesägten Siliziumkörper durch folgende Verfahrensschritte beschreiben:

Naßchemisches Ätzen der ausgesägten Siliziumkörper bzw. Dioden, Montage der Dioden, Eintauchen der montierten Dioden in Ätzkörben in Ätzbecken, Neutralisation der Ätzlösung und nachfolgende ausgiebige Spülung und Trocknung der Dioden.

Als Hilfsstoffe werden bei den bekannten Verfahren eine Ätzlösung, eine Neutralisationslösung sowie Wasserstoffperoxid benötigt, was neben hohen Umweltschädigungen aufgrund der verwendeten Stoffe mit einem hohen Energieverbrauch und Verbrauch von deionisiertem Wasser verbunden ist. So findet das Naßätzen beispielsweise bei Temperaturen oberhalb von 90° C statt und es ist eine Spülkaskade zur anschließenden Reinigung der geätzten montierten Dioden erforderlich.

In der US-A 5,693,182 wird mit Plasma Silizium bearbeitet. Da bei P-N-Übergängen von Leistungsdioden kein Plasma vorhanden sein darf, sind zu deren Reinigungen hier keine Hinweise entnehmbar. In der US 5,350,480 wird die Behandlung von Verschmutzungen und Beschädigungen auf Oberflächen mittels eines anisotropen Strahls offenbart. Es wird erwähnt, wie durch verschiedene Einstellungen des Gasstrahls die Oberflächen behandelt werden. In der EP 0878824 wird eine Ätzvorrichtung beschrieben, die speziell auf die Verwendung von XeF₂ abgestimmt ist. Eine Reinigung ist nicht erwähnt oder angestrebt. Im JP Abstract zur JP-A-8031785 sind nur allgemeine Hinweise zum Handhaben von Teilen beim Sägen entnehmbar. Bei dem in der DE 35 06 995 beschriebenen Verfahren wird nicht mit Silizium gearbeitet.

**Vorteile der Erfindung**

Das erfindungsgemäße Verfahren mit den kennzeichnenden Merkmalen des Hauptanspruches hat gegenüber dem Stand der Technik den Vorteil, daß damit Siliziumkörper, insbesondere oberflächlich metallisierte ausgesägte Teile eines Siliziumwafers mit einem gasförmigen Ätzmedium, das über eine chemische Reaktion selektiv nahezu ausschließlich Silizium ätzt, wobei gasförmige Reaktionsprodukte entstehen, geätzt werden können. Während dieser selektiven Ätzung werden gleichzeitig insbesondere oberflächliche Ausbrüche und/oder Verunreinigungen und/oder Schäden am Kristallgitter der Siliziumkörper beseitigt. Das erfindungsgemäße Verfahren eignet sich weiter vorteilhaft zum Abtrag beschädigter Siliziumzonen von insbesondere ausgesägten Siliziumkörpern, wie sie beispielsweise bei der Herstellung von Silizium-Leistungsdioden auftreten. Es ist zuverlässig, kostengünstig und überwindet die bekannten Nachteile flüssiger Ätzmedien.

Daneben ist es besonders vorteilhaft, daß es sich bei dem erfindungsgemäßen Verfahren um einen sogenannten "Batch-Prozeß" bzw. einen Prozeß auf Waferlevel handelt. Somit ist sehr vorteilhaft kein Einzelchip-Handling erforderlich, das heißt, es können gleichzeitig alle ausgesägten Siliziumkörper bzw. -chips eines Wafers gleichzeitig geätzt werden, was mit deutlich geringerem Platzbedarf und nur einem Prozeß- bzw. Handlingschritt verbunden ist. Natürlich ist es mit dem erfindungsgemäßen Verfahren bei entsprechenden Erfordernissen aber auch weiterhin möglich, wie bisher fertig montierte Einzeldioden zu überätzen. In diesem Fall wird lediglich das an sich bekannte Naßätzen durch ein Ätzen mit einem gasförmigen Ätzmedium ersetzt.

Weiter ist vorteilhaft, daß bei dem erfindungsgemäßen Verfahren zur selektiven Ätzung keine Flüssigkeit involviert ist, so daß eine saubere Gasphasenätzung der insbesondere ausgesägten Siliziumkörper erzielt wird. Überdies weist das erfindungsgemäße Verfahren auch eine geringe Selektivität gegenüber Dotierkonzentrationen auf, so daß vorteilhafte Ätzkantenprofile entstehen und insbesondere ein sogenannter "Borbalkon" an den ausgesägten und überätzten Dioden vermieden wird, was gleichzeitig mit höherer mechanischer Stabilität und einer Verringerung von Ausfallraten verbunden ist.

Sehr vorteilhaft ist weiterhin die selektive Entfernung beschädigter Siliziumzonen, von Ausbrüchen oder Verunreinigungen, sowie die planarisierende Wirkung des erfindungsgemäßen Verfahrens. So wird aufgrund der hohen Selektivität des verwendeten gasförmigen Ätzmediums und der damit an der Oberfläche des Siliziumkörpers durchgeführten chemischen Reaktion, sowie insbesondere der Selektivität dieser Reaktion auf Beschädigungen in diesen Zonen, ein insgesamt deutlich höherer Ätzabtrag ermöglicht, wobei beschädigte Stellen, insbesondere im Kantenbereich der ausgesägten Siliziumkörper, automatisch stärker geätzt werden.

Vorteilhafte Weiterbildungen der Erfindung ergeben sich aus den in den Unteransprüchen genannten Maßnahmen.

So bietet das erfindungsgemäße Verfahren den Vorteil, daß die Ätzraten, beispielsweise über die Zusammensetzung des gasförmigen Ätzmediums, gezielt einstellbar sind. Auf diese Weise ist es einerseits möglich, bei Bedarf geringe Ätzabtragsraten einzustellen, was zu einer höheren Reproduzierbarkeit und damit zu einer insgesamt geringeren Prozeßzeit führt. Andererseits ist es jedoch auch möglich, sehr hohe Ätzraten, insbesondere beim Einsatz von Chlortrifluorid bzw. Bromtrifluorid, einzustellen und somit die eigentliche Ätzzeit wesentlich zu verkürzen.

Die sehr hohe Selektivität des erfindungsgemäßen Verfahrens gegenüber Nicht-Silizium ist durch eine oberflächenkatalytische Initiierung der Ätzreaktion bedingt, so daß sich überdies vorteilhaft sehr viele Materialien als Ätzmaske eignen.

Somit kann beispielsweise selbst eine oberflächliche Metallisierung des Siliziumwafers, die als spätere Diodenmetallisierung dient, als Ätzmaske während des Ätzvorgangs mit dem gasförmigen Ätzmedium dienen, ohne dabei selbst nennenswert angegriffen zu werden. In diesem Zusammenhang ist es auch vorteilhaft, daß eine verwendete Sägefolie und eine aufgebrachte Adhäsionsschicht zwischen dieser Sägefolie und dem darauf befestigen Siliziumwafer aufgrund der hohen Selektivität des Ätzmediums gegenüber Nicht-Silizium ebenfalls nicht wesentlich angegriffen wird. Im übrigen kann als zusätzlicher Schutz der Oberflächenmetallisierung des Siliziumwafers vorteilhaft zusätzlich in an sich bekannter Weise auch eine Lackschicht, beispielsweise durch Aufschleudern, ganzflächig aufgebracht werden.

Bei den für das erfindungsgemäße Verfahren geeigneten Interhalogen- ist überdies bei geeigneten Prozeßbedingungen sichergestellt, daß kein freies Chlor, Brom oder Jod auftritt, so daß lediglich ein sehr geringes Risiko einer Korrosion nach der Durchführung des Ätzverfahrens besteht.

Weitere Vorteile des erfindungsgemäßen Verfahrens liegen in dem geringen Energieverbrauch, da kein Aufheizen beispielsweise der Dioden oder Ätzbäder erforderlich ist, in einem geringen Chemikalienverbrauch und seiner Umweltverträglichkeit. So können beispielsweise entstehende Abgase durch eine Nachbehandlung sehr leicht unschädlich entsorgt werden, so daß kein Sondermüll entsteht. Dazu eignet sich vorteilhaft ein Waschen der Abgase in Kalkwasser d.h. einer wäßrigen Calciumhydroxidlösung in einem sogenannten "Gaswäscher" ($Ca(OH)_2 + 2HF \rightarrow CaF_2\downarrow + 2\,H_2O$)

Als Ätzmedium eignet sich besonders gasförmiges oder in die Gasphase überführtes Chlortrifluorid, Bromtrifluorid, Iodpentafluorid, oder eine Mischung dieser Verbindungen. In diesem Fall entsteht als Reaktionsprodukt beispielsweise Siliziumtetrafluorid.

**Ausführungsbeispiele**

Bei dem erfindungsgemäßen Verfahren zur Beseitigung von Schäden, Ausbrüchen, Verunreinigungen oder Schäden am Kristallgitter von Siliziumkörpern durch selektive Ätzung von Silizium wird allgemein die Eigenschaft gewisser Fluorverbindungen, sogenannter Interhalogene, ausgenützt, Silizium spontan, das heißt durch Kontakt zwischen der Fluorverbindung und Silizium zu ätzen, wobei dieser Ätzangriff aus der Gasphase erfolgt und gasförmige Reaktionsprodukte entstehen. Dazu wird beispielsweise eine siliziumätzende Fluorverbindung gasförmig einer Reaktionskammer eines an sich bekannten Reaktors zugeführt, in der die zu ätzenden Siliziumkörper zuvor eingebracht wurden. Durch Adsorption der Gasmoleküle des gasförmigen Ätzmediums auf den zugänglichen Siliziumoberflächen kommt es dabei zu einer spontanen, oberflächenkatalytischen Aufspaltung des verwendeten Ätzmediums unter Freisetzung von Fluorradikalen, welche mit dem Silizium zu einem flüchtigen Produkt, beispielsweise $SiF_x$ (x = 2, 3, 4), reagieren. Das bekannteste Reaktionsprodukt einer derartigen Reaktion ist beispielsweise das stabile Siliziumtetrafluorid $SiF_4$. Der an sich bekannte Mechanismus kann dabei wie folgt beschrieben werden, wobei X für Cl, Br, oder I steht und n die Anzahl der Fluoratome in der jeweiligen Verbindung ist:

1. Adsorption:

$$XF_n \rightarrow XF_n^{adsorb}$$

2. oberflächenkatalytische Zersetzung:

$$XF_n^{adsorb} \rightarrow XF_{n-1}^{adsorb} + F^{\bullet,adsorb}$$

3. chemische Umsetzung:

$$Si + xF^{\bullet,adsorb} \rightarrow SiF_x \quad (x = 1, 2, 3, 4)$$

4. Desorption der Reaktionsprodukte:

$$SiF_x \rightarrow SiF_x \uparrow \quad (x = 2, 3, 4)$$

insbesondere:

$$Si + 4F^{\bullet,adsorb} \rightarrow SiF_4 \uparrow$$

Beispiele von geeigneten Verbindungen der Art $XF_n$ sind die Interhalogenverbindungen Chlortrifluorid, Bromtrifluorid und Iodpentafluorid. Die Verbindungen Chlortrifluorid und Bromtrifluorid sind dabei in der Halbleiterindustrie an sich bekannt und werden dort im wesentlichen zur Waferreinigung oder Reinigung von Waferbehandlungsvorrichtungen eingesetzt.

Während es sich beim Chlortrifluorid und beim Bromtrifluorid um Flüssigkeiten mit einem Dampfdruck von 1 bar bei 150°C handelt, ist Iodpentafluorid eine zähe Flüssigkeit mit einem Dampfdruck von ca. 20 mbar bei 15°C. Somit können Chlortrifluorid und Bromtrifluorid durch ihren hohen Dampfdruck direkt aus einer Gasflasche entnommen werden, während Iodpentafluorid zunächst erst durch eine geeignete Verdampfervorrichtung und bevorzugt unter Einsatz erhöhter Temperatur in die Gasphase überführt werden müssen. Im Falle des flüssigen Iodpentafluorids wird dazu bevorzugt ein sogenannter "Bubbler" verwendet, in dem die Flüssigkeit mit einem Inertgas, beispielsweise Helium, als Trägergas "gebubbelt" wird und das Gasgemisch anschließend in die Reaktionskammer geleitet wird.

Bei den Interhalogenverbindungen Chlortrifluorid und Bromtrifluorid erfolgt der Abbau in einem ersten Reaktionsschritt der Ätzreaktion unter Freisetzung von Fluorradikalen bis zum stabilen Chlorfluorid (ClF) bzw. zum instabilem Bromfluorid (BrF), wobei jeweils zwei Fluorradikale generiert werden.

Beim Iodpentafluorid erfolgt der Übergang zunächst bis zum relativ stabilen Iodtrifluorid,

Bei der Durchführung des erfindungsgemäßen Verfahrens wird als Ausführungsbeispiel zunächst von einem Siliziumwafer ausgegangen, aus dem Siliziumleistungsdioden hergestellt werden sollen, und der einseitig über einen ganzflächigen Dotierschritt in an sich bekannter Weise mit einer n-Dotierung und einseitig über einen ganzflächigen Dotierschritt in an sich bekannter Weise mit einer p-Dotierung versehen wurde. Dadurch bildet sich im Inneren des Siliziumwafers ganzflächig ein pn-Übergang aus. Danach wurde der derart vorbehandelte Wafer beidseitig mit einer an sich bekannten ganzflächigen Metallisierung aus CrNiVAg versehen.

Dieser Siliziumwafer wird nun auf einer an sich bekannten, kommerziell erhältlichen flexiblen Sägefolie, beispielsweise aus Polyvinylchlorid (PVC) oder Polycarbonat, mittels einer darauf befindlichen Adhäsionsschicht befestigt, und über einen Sägevorgang in an sich bekannter Weise in etwa 5 x 5 mm$^2$ große Siliziumkörper in Form von Quadraten oder Sechsecken zersägt, die nach Abschluß des Herstellungsverfahrens als Siliziumleistungsdioden eingesetzt werden.

Nach dem Zersägen des Wafers verbleiben die erzeugten ausgesägten Siliziumkörper dann erfindungsgemäß bevorzugt zunächst im Verbund auf der Sägefolie, so daß in diesem Verfahrensstadium keine Einzelchips entstehen, sondern stets ein ganzer Verbund ausgesägter Siliziumkörper hantiert wird.

Zur mechanischen Stabilisierung wird die Sägefolie beim Sägen und im Laufe der weiteren Verfahrensschritte im übrigen bevorzugt mit ihrem Rand in einen festen Rahmen eingespannt, so daß sie besonders leicht gegriffen und automatisch gehandhabt werden kann. Nach dem Zersägen des Wafers wird die Sägefolie bevorzugt dann zunächst expandiert, um den Abstand der Siliziumkörper zu vergrößern, und so dem im weiteren eingesetzten gasförmigen Ätzmedium, beispielsweise Chlortrifluorid, einen verbesserten Zutritt zu den Seitenwänden der einzelnen ausgesägten Siliziumkörper zu ermöglichen. Dazu wird bevorzugt ein sogenannter Expansionsrahmen als stabiler Rahmen für die Handhabung der ansonsten flexiblen Sägefolie verwendet.

In jedem Fall ist es wichtig, daß nach dem Sägen des Siliziumwafers und dem Expandieren der Sägefolie vor dem Ätzen eine sorgfältige Trocknung der herausgesägten Siliziumkörper durchgeführt wird. Damit wird gewährleistet, daß keine Feuchtigkeit in die Reaktionskammer des im weiteren zur Durchführung der eigentlichen selektiven Ätzung der Siliziumkörper verwendeten Reaktors eingetragen wird.

Es empfiehlt sich dazu, die Beladung der Reaktionskammer des Reaktors mit den auf der Sägefolie plazierten ausgesägten Siliziumkörpern im Waferverbund über eine Beladevorrichtung, beispielsweise eine Schleuse, vorzunehmen, die die Möglichkeit zur Evakuierung und Beheizung, beispielsweise eine Strahlungsheizung mit entsprechenden Lampen, beinhaltet.

Durch das Abpumpen der Beladevorrichtung auf Vakuum und die gleichzeitige Erwärmung des auf der Sägefolie befindlichen, in Siliziumkörper zersägten Wafers in der Beladevorrichtung, beispielsweise über eine Strahlungsheizung, werden Feuchtigkeitsreste besonders effizient entfernt, bevor der in Siliziumkörper zersägte Wafer dann in die eigentliche Reaktionskammer des Reaktors gelangt, in der nach Einleitung des gasförmigen Ätzmediums die erläuterte Ätzreaktion stattfindet. Die Anwesenheit von Feuchtigkeit würde Korrosionseffekte in diesem Stadium massiv fördern und ist daher unerwünscht.

Da die eingesetzten Ätzgase zur Freisetzung von Fluorradikalen einer oberflächenkatytischen Zersetzung bedürfen, die nur im Rahmen der eigentlichen Ätzreaktion mit dem Silizium abläuft, besteht eine außerordentlich hohe Selektivität der Ätzreaktion gegenüber Nicht-Siliziummaterialien. Es ist daher in sehr einfacher Weise möglich, die Ätzbedingungen, beispielsweise durch die Wahl und die Konzentration des gasförmigen Ätzmediums, so einzustellen, daß weder Metalle noch Kunststoffe, sondern lediglich Siliziumoberfächen von der verwendeten Ätzchemie in nennenswertem Umfang angegriffen werden.

Insofern genügen Metallschichten, insbesondere aufgebrachte Oberflächenmetallisierungen, und auch die verwendete Sägefolie bereits voll den Ansprüchen an eine Maskierung der Ätzreaktion, um nur eine durch den Sägevorgang beschädigte Sägekante, nicht aber die gesamte Siliziumoberlfäche abzutragen. Falls ein zusätzlicher Schutz der Oberflächenmetallisierungen oder Metallschichten vor selbst geringen Ätzangriffen erforderlich ist, kann dies in einfacher Weise durch das zusätzliche, bevorzugt ganzflächige Aufbringen, insbesondere Aufschleudern, einer an sich bekannten Lackschicht auf die Oberfläche des Siliziumwafers erfolgen.

Nach dem Einbringen des auf der Sägefolie befestigten, getrockneten und gesägten Siliziumwafers in die Reaktionskammer des Reaktors wird in diese dann das gasförmige Ätzmedium eingelassen. Bei der Verwendung der Interhalogenverbindungen Chlortrifluorid bzw. Bromtrifluorid erfolgt dieser Einlaß über an sich bekannte Flußregler oder Drosselventile, wobei der Prozeßdruck vom Niederdruckbereich bzw. Vakuum bis in den Atmospärendruckbereich reichen kann. Mit den beiden genannten Gasen ist beispielsweise ein Prozeß im Druckbereich von 0,1 bis 1000 mbar unter kontrollierten Flußbedingungen möglich.

Soll bei höheren Drücken prozessiert werden, ist es vorteilhaft, das Reaktivgas mit einem Inertgas, beispielsweise Helium, zu verdünnen. Durch eine Verdünnung mit Helium um einen Faktor 10 bis 100 läßt sich überdies die Ätzreaktion und die Ätzgeschwindigkeit sehr einfach kontrollieren und es wird die Aggressivität des verwendeten gasförmigen Ätzmediums reduziert, was auch einen möglichen chemischen Angriff auf Gasleitungen und das Innere der Reaktionskammer vermindert.

Durch einen Einsatz eines verdünnenden Inertgases ist es weiter möglich auch bei Atmosphärendruck zu arbeiten, indem der Partialdruck beispielsweise von Chlortrifluorid oder Bromtrifluorid durch entsprechende Verdünnung mit Helium auf einen Bereich von einigen 10 mbar beschränkt wird, was einerseits für eine möglichst hohe Ätzrate noch ausreichend ist, andererseits aber auch zu einem über den Zustrom der Ätzspezies gut zu kontrollierenden Ätzprozeß führt.

Wird Iodpentafluorid als Ätzmedium verwendet, ist dies zunächst in einem Verdampfer in die Gasphase zu überführen, was den Arbeitsdruck auf etwa 20 mbar beschränkt. Alternativ kann man jedoch auch einen sogenannten "Bubbler" benutzen, um das flüssige Iodpentafluorid mit einem Inertgas, beispielsweise Helium, zu "bubbeln" und das derart verdünnte Gasgemisch der Reaktionskammer zuzuführen. Beide Vorgehensweisen sind dem Fachmann an sich bekannt.

Nach der Einleitung des gasförmigen Ätzmediums in die Reaktionskammer erfolgt dann die eigentliche Ätzung der ausgesägten Siliziumkörper, wobei bevorzugt an der Sägekante speziell die beschädigten Bereiche der Kristallstruktur, das heißt sogenannte "damage zones", abgetragen werden und eine Planarisierung der gesägten Oberflächen erfolgt.

Die dabei entstehenden gasförmigen Reaktionsprodukte aus der Reaktion des verwendeten gasförmigen Ätzmediums mit den Siliziumoberflächen werden entweder im Fall der Verwendung einer Durchflußanlage kontinuierlich abgepumpt oder reichern sich in einer einmalig befüllten und dann geschlossenen Reaktionskammer zunächst an, bis nach Abschluß der Ätzung der Siliziumkörper schließlich alles Gas aus der Reaktionskammer abgepumpt wird.

In jedem Fall ist sicherzustellen, daß durch genügend langes Abpumpen und einen genügend niedrigen Enddruck von bevorzugt weniger als 0,1 $\mu$bar beim Abpumpen sichergestellt wird, daß sich keine Ätzgasreste mehr in der Reaktionskammer befinden, bevor die auf der Sägefolie befindlichen, aus dem Siliziumwafer ausgesägten Siliziumkörper wieder über die Schleuse oder die Beladevorrichtung aus der Reaktionskammer des Reaktors ausgeschleust werden.

Beim Ausschleusen ist es weiter zweckmäßig, daß auch in der Schleuse zwischen der Reaktionskammer und der umgebenden Atmosphäre ein Vakuum vorliegt. Dieses Vakuum hat bevorzugt einen Druck von weniger als 0,1 $\mu$bar, was durch Einsatz einer Turbomolekularpumpe problemlos zu erreichen ist.

Dabei wird der auf der Sägefolie befestigte, in Siliziumkörper zersägte Wafer bevorzugt nach dem Ätzen in der Schleuse wieder, beispielsweise über eine Strahlungsheizung, erwärmt. Damit werden vor dessen Herausnahme aus der Schleuse möglichst weitgehend Reste von Ätzspezies d.h. heißt Reste des gasförmigen Ätzmediums oder Reste von gasförmigen Reaktionsprodukten von den ausgesägten überätzten Siliziumkörpern bzw. deren von der Ätzung betroffenen Oberflächen entfernt.

Derartige Reste, die an der Oberfläche des Siliziumkörpers verbleiben, würden an Luft durch die Einwirkung von Luftfeuchtigkeit zu Korrosionseffekten führen.

Nach dem Ausschleusen der prozessierten Siliziumkörper aus dem Reaktor werden diese schließlich einzeln von der Sägefolie aufgenommen und in an sich bekannter Weise als Dioden aufgebaut. Dabei werden im weiteren in an sich bekannter Weise die Siliziumkanten passiviert, um die Stabilität der pn-Übergänge und eine hohe Performance der Silizium-Leistungsdioden über deren Lebensdauer zu garantieren.

### Patentansprüche

1. Verfahren zur Beseitigung von Ausbrüchen, Verunreinigungen und/oder Schäden am Kristallgitter durch selektive Ätzung mindestens eines Siliziumkörpers, insbesondere von Leistungsdioden, wobei der Siliziumkörper zumindest bereichsweise mit einem gasförmigen Ätzmedium in Kontakt gebracht wird, das über eine chemische Reaktion selektiv Silizium ätzt, wobei während der Ätzung gasförmige Reaktionsprodukte entstehen, wobei das Ätzmedium eine gasförmige oder eine in die Gasphase überführte Interhalogenverbindung, insbesondere Chlortrifluorid, Bromtrifluorid, Iodpentafluorid oder eine Mischung dieser Verbindungen enthält, wobei der Siliziumkörper oder eine Vielzahl von Siliziumkörpern vor der Ätzung aus einem Siliziumwafer ausgesägt werden, und wobei der Siliziumwafer zunächst auf einem Tragkörper, insbesondere einer in einem Rahmen eingespannten Sägefolie, befestigt wird.

2. Verfahren nach Anspruch 1, **dadurch gekennzeichnet, dass** das Reaktionsprodukt Siliziumtetrafluorid ist.

3. Verfahren nach Anspruch 1, **dadurch gekennzeichnet, dass** das Ätzen bei einem Druck von 0,1 mbar bis 1000 mbar erfolgt.

4. Verfahren nach Anspruch 1, **dadurch gekennzeichnet, dass** das gasförmige Ätzmedium zur Kontrolle der Aggressivität des Ätzmediums und/oder der Ätzgeschwindigkeit mit einem Inertgas, insbesondere Helium, verdünnt wird.

5. Verfahren nach Anspruch 1, **dadurch gekennzeichnet, dass** das Ätzmedium oder ein Bestandteil des Ätzmediums mittels einer Feststoffquelle aus der festen Phase durch thermische Sublimation in die Gasphase überführt wird, oder mittels eines Bubblers durch Einleiten eines Inertgases aus der flüssigen Phase in die Gasphase überführt wird, oder aufgrund seines Dampfdruckes bei einer definierten Temperatur aus der flüssigen oder festen Phase in der Gasphase überführt wird.

6. Verfahren nach einem der Ansprüche 1 bis 5, **dadurch gekennzeichnet, dass** die Siliziumkörper nach dem Aussägen zunächst auf dem Tragkörper, insbesondere der Sägefolie, belassen und im Verbund mit dem Tragkörper hantiert werden.

7. Verfahren nach einem der Ansprüche 1 bis 6, **dadurch gekennzeichnet, dass** die Sägefolie nach dem Aussägen der Siliziumkörper und vor der selektiven Ätzung zur Vergrößerung des Abstandes der Siliziumkörper expandiert wird, wobei der Rahmen als Expansionsrahmen für die Sägefolie eingesetzt wird.

8. Verfahren nach einem der Ansprüche 1 bis 7, **dadurch gekennzeichnet, dass** die ausgesägten Siliziumkörper vor der selektiven Ätzung, insbesondere durch Erwärmen über eine Strahlungsheizung im Vakuum bei einem Druck von weniger als 0,1 $\mu$bar, getrocknet werden.

9. Verfahren nach mindestens einem der vorangehenden Ansprüche, **dadurch gekennzeichnet, dass** die Ätzrate beim Ätzen des Siliziumkörpers über die Auswahl und/oder die Zusammensetzung des Ätzmediums und/oder die Ätztemperatur eingestellt wird.

10. Verfahren nach mindestens einem der vorangehenden Ansprüche, **dadurch gekennzeichnet, dass** die beim Ätzen entstehenden gasförmigen Reaktionsprodukte während und/oder nach der Ätzung der Siliziumkörper abgeführt werden.

11. Verfahren nach mindestens einem der vorangehenden Ansprüche, **dadurch gekennzeichnet, dass** die geätzten Siliziumkörper nach dem Ätzen in einer Reaktionskammer in einer Schleuse unter Vakuum, insbesondere bei einem Druck von weniger als 0,1 $\mu$bar, und bei erhöhter Temperatur von Resten des Ätzmediums oder von Resten von Reaktionsprodukten befreit werden.

12. Verwendung des Verfahrens nach mindestens einem der vorangehenden Ansprüche zur Kantenätzung von Leistungsdioden.

## Claims

1. Method for removing spalling, contamination and/or damage at the crystal lattice by selective etching of at least one silicon body, in particular of power diodes, wherein the silicon body, at least in regions, is brought into contact with a gaseous etching medium which selectively etches silicon by means of a chemical reaction, wherein gaseous reaction products arise during the etching, wherein the etching medium contains a gaseous interhalogen compound or an interhalogen compound converted to the gas phase, in particular chlorine trifluoride, bromine trifluoride, iodine pentafluoride or a mixture of said compounds, wherein the silicon body or a multiplicity of silicon bodies are sawn from a silicon wafer before the etching, and wherein the silicon wafer is firstly fixed on a carrier body, in particular a sawing film clamped in a frame.

2. Method according to Claim 1, **characterized in that** the reaction product is silicon tetrafluoride.

3. Method according to Claim 1, **characterized in that** the etching is effected at a pressure of 0.1 mbar to 1000 mbar.

4. Method according to Claim 1, **characterized in that** the gaseous etching medium is diluted with an inert gas, in particular helium, in order to control the aggressivity of the etching medium and/or the etching speed.

5. Method according to Claim 1, **characterized in that** the etching medium or a constituent of the etching medium is converted from the solid phase to the gas phase by thermal sublimation by means of a solid source, or is converted from the liquid phase to the gas phase by means of a bubbler by introduction of an inert gas, or is converted from the liquid or solid phase to the gas phase on account of its vapour pressure at a defined temperature.

6. Method according to any of Claims 1 to 5, **characterized in that** the silicon bodies, after being sawn out, are firstly left on the carrier body, in particular the sawing film, and handled in an assemblage with the carrier body.

**7.** Method according to any of Claims 1 to 6, **characterized in that**, after the silicon bodies have been sawn out and before the selective etching, the sawing film is expanded in order to increase the distance between the silicon bodies, wherein the frame is used as an expansion frame for the sawing film.

**8.** Method according to any of Claims 1 to 7, **characterized in that**, before the selective etching, the sawn-out silicon bodies are dried in particular by heating by means of a radiant heating system in vacuo at a pressure of less than 0.1 $\mu$bar.

**9.** Method according to at least one of the preceding claims, **characterized in that** the etching rate during the etching of the silicon body is set by means of the choice and/or the composition of the etching medium and/or the etching temperature.

**10.** Method according to at least one of the preceding claims, **characterized in that** the gaseous reaction products which arise during etching are carried away during and/or after the etching of the silicon bodies.

**11.** Method according to at least one of the preceding claims, **characterized in that** the etched silicon bodies are freed of residues of the etching medium or of residues of reaction products after the etching in a reaction chamber in a lock under vacuum, in particular at a pressure of less than 0.1 $\mu$bar, and at elevated temperature.

**12.** Use of the method according to at least one of the preceding claims for the edge etching of power diodes.

**Revendications**

**1.** Procédé d'élimination de fragments rompus, d'encrassements et/ou de dommages dans un réseau cristallin par gravure sélective d'au moins un corps en silicium, en particulier de diodes de puissance, dans lequel
au moins certaines parties du corps en silicium sont mises en contact avec un fluide de gravure gazeux qui grave sélectivement le silicium par une réaction chimique,
des produits de réaction gazeux sont dégagés pendant la gravure,
le fluide de gravure contient un composé interhalogéné gazeux ou amené en phase gazeuse, en particulier du trifluorure de chlore, du trifluorure de brome, du pentafluorure d'iode ou un mélange de ces composés,
le corps en silicium ou plusieurs corps en silicium sont sciés dans une galette de silicium avant la gravure et la galette de silicium est d'abord fixée sur un corps de support et en particulier sur une feuille de sciage tendue dans un cadre.

**2.** Procédé selon la revendication 1, **caractérisé en ce que** le produit de réaction est le tétrafluorure de silicium.

**3.** Procédé selon la revendication 1, **caractérisé en ce que** la gravure a lieu à une pression de 0,1 mbar à 1 000 mbars.

**4.** Procédé selon la revendication 1, **caractérisé en ce que** pour contrôler l'agressivité du fluide de gravure et/ou la vitesse de gravure, le fluide de gravure gazeux est dilué avec un gaz inerte et en particulier avec de l'hélium.

**5.** Procédé selon la revendication 1, **caractérisé en ce que** le fluide de gravure ou un composant du fluide de gravure est amené au moyen d'une source de solide de la phase solide à la phase gazeuse par sublimation thermique, est amené de la phase liquide à la phase gazeuse au moyen d'un barboteur par introduction d'un gaz inerte ou est amené de la phase liquide ou de la phase solide à la phase gazeuse grâce à sa tension de vapeur à une température définie.

**6.** Procédé selon l'une des revendications 1 à 5, **caractérisé en ce qu'**après le sciage, le corps en silicium est d'abord placé sur le corps de support et en particulier la feuille de sciage et est manipulé en même temps que le corps de support.

**7.** Procédé selon l'une des revendications 1 à 6, **caractérisé en ce qu'**après le sciage du corps en silicium et avant la gravure sélective, la feuille de sciage est agrandie pour agrandir la distance entre les corps en silicium, le cadre étant utilisé comme cadre d'agrandissement de la feuille de sciage.

**8.** Procédé selon l'une des revendications 1 à 7, **caractérisé en ce qu'**avant la gravure sélective, le corps en silicium scié est séché, en particulier en étant chauffé par chauffage radiant sous vide à une pression inférieure à 0,1 $\mu$bar.

**9.** Procédé selon au moins l'une des revendications précédentes, **caractérisé en ce que** lors de la gravure du corps en silicium, la vitesse de gravure est ajustée par la sélection et/ou la composition du fluide de gravure et/ou de la température de gravure.

**10.** Procédé selon au moins l'une des revendications précédentes, **caractérisé en ce que** les produits de réaction gazeux qui se dégagent lors de la gravure sont évacués pendant et/ou après la gravure du corps en silicium.

**11.** Procédé selon au moins l'une des revendications précédentes, **caractérisé en ce qu'**après la gravure dans une chambre de réaction, les corps en silicium gravé sont débarrassés des restes de fluide de gravure ou des restes de produits de réaction dans un sas sous vide placé en particulier à une pression inférieure à 0,1 $\mu$bar et à haute température.

**12.** Utilisation du procédé selon au moins l'une des revendications précédentes pour la gravure des chants de diodes de puissance.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5693182 A
- US 5350480 A
- EP 0878824 A
- JP 8031785 A
- DE 3506995